# EUROPEAN PATENT APPLICATION

(11) **EP 2 940 415 A1**
(43) Date of publication of application: **04.11.2015**
(21) Application number: 13868439.4
(22) Date of filing: 26.12.2013
(51) Int. Cl.: F28D 15/02, H05K 7/20

(54) **COOLING DEVICE**

(30) Priority: 27.12.2012 JP 2012285231
(71) Applicant: Furukawa Electric Co., Ltd., Chiyoda-ku Tokyo 100-8322 (JP)
(72) Inventor: YAMADA Hiroshi, Tokyo 100-8322 (JP); OKAMOTO Tsuyoshi, Tokyo 100-8322 (JP); ISEMURA Masakazu, Tokyo 100-8322 (JP); HASHIMOTO Nobuyuki, Tokyo 100-8322 (JP)
(74) Representative: Jordan, Volker Otto Wilhelm
(86) International application number: PCT/JP2013/084918
(87) International publication number: WO 2014/104204

(57) **Abstract**

Provided is a cooling apparatus having improved cooling capacity and vibration resistance, while reducing an airflow resistance and ensuring a sufficient contact area between the fins and the heat pipes. A cooling apparatus (1) includes a heat receiving block (2) that is thermally connected to an electronic component constituting a heating element, a heat pipe (3) that receives heat from the heat receiving block (2) and transports the heat, and a plurality of fins (4). The heat pipe (3) is provided to stand on the heat receiving block (2) with a U-shaped face of the U-shape being disposed perpendicular to a wind direction, the heat pipes next to each other being arranged to overlap in the wind direction.

## Description

### Technical Field

The present invention relates to a cooling apparatus that cools a heating element, and particularly relates to a cooling apparatus that cools, by air-cooling, electronic components such as power conversion devices installed in moving objects such as railway vehicles, aircrafts and marine vessels.

### Background Art

A moving object such as a railway vehicle is provided with a power control apparatus for controlling a drive motor or the like, the power control apparatus including power devices such as IGBTs and other electronic components disposed in a power control housing. Since these electronic components generate heat due to heat loss, a cooling apparatus is attached to a heating element to efficiently cool the installed electric components by utilizing a wind caused by forced-air cooling or by a movement of the vehicle.

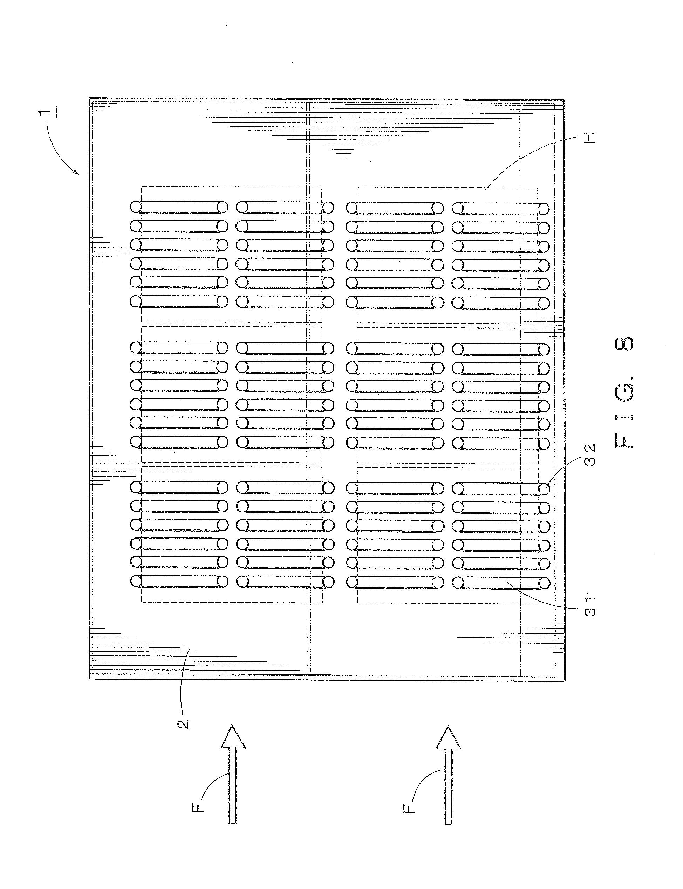

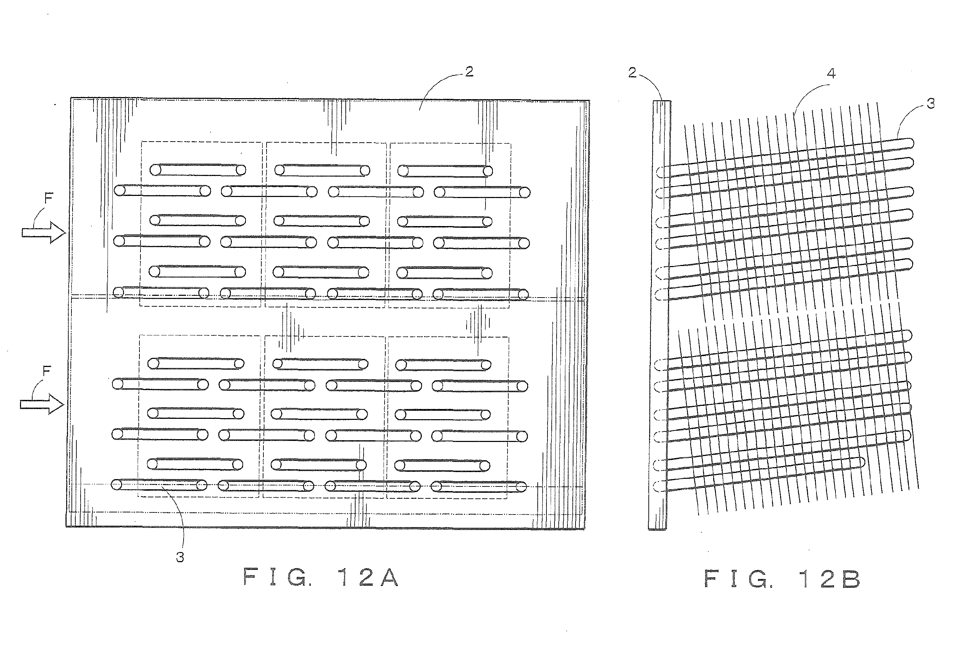

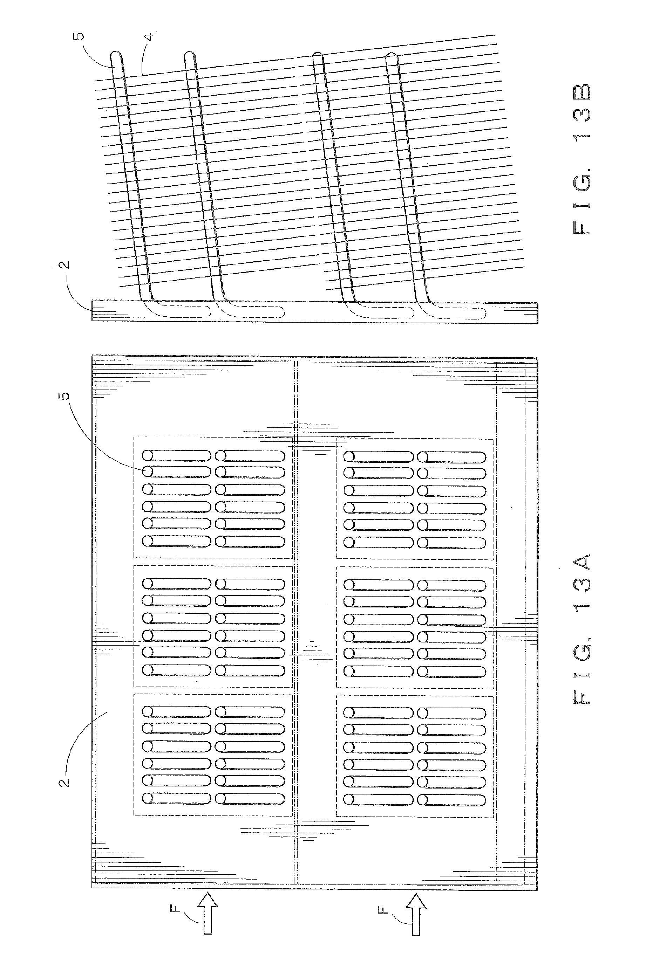

An example of a conventional cooling apparatus is shown in FIG. 12. A cooling apparatus shown in FIG. 12 includes a heat receiving block 2, heat pipes 3, and fins 4, and, in order to perform cooling using aerodynamic drags, U-shaped heat pipes are arranged horizontally along a direction of travel (direction of air stream). Also, as a structure different from FIG. 13, a cooling apparatus has been proposed that is constituted by arranging L-shaped heat pipes vertically along a direction of travel (see FIG. 8 of Patent Document 1).

### Document List

### Patent Document(s)

Patent Document 1: Japanese Laid-open Patent Publication No. 10-223814

### Summary of Invention

### Technical Problem

With a conventional cooling apparatus shown in FIG. 12, in a case where the number of heat pipes is increased, a flow of wind is disturbed, and thus there was a tendency that a temperature of a downstream-side element increases due to an influence of an increase in a drag by an airflow (airflow resistance). With the structure shown in FIG. 13 in which L-shaped heat pipes are arranged vertically along a direction of travel, fin efficiency is decreased since a smaller number of heat pipes are joined to the fins, and also there is a problem in vibration resistance since the joining points between the fins and the heat pipes is biased.

The present invention is suggested to solve the aforementioned problem of the prior art, and it is an object of the invention to provide a cooling apparatus having an improved cooling capacity and vibration resistance, while reducing an airflow resistance and ensuring a sufficient contact area between the fins and the heat pipes.

### Solution to Problem

In order to achieve the aforementioned object, the present invention includes a heat receiving block that is thermally connected to a heating element, a heat pipe group that is provided to stand on a surface of the heat receiving block, the heat pipe group being configured to receive heat from the heat receiving block and to transport the heat, and a plurality of fins attached to the heat pipe group, and characterized in that a heat pipe constituting the heat pipe group is a U-shaped heat pipe having a bottom portion that is bent and a straight portion that is linear, the U-shaped heat pipe being provided to stand on the heat receiving block with a U-shaped face of the U-shaped heat pipe being perpendicular to a wind direction of an incoming wind, the heat pipes next to each other being disposed in an overlapped manner in the wind direction, each of the straight portions being provided to incline upwardly in a case where a surface of the heat receiving block whereto the heat pipe group is attached is arranged perpendicular.

With the aspect described above, an airflow resistance can be suppressed, since the heat pipe formed in a U-shape is disposed on the heat receiving block with a U-shaped face thereof being arranged perpendicular to the direction of the wind. Conventionally, since the U-shaped heat pipe is disposed with the U-shaped face thereof being arranged parallel to the direction of the wind, an increase in the number of heat pipes will result in a dense arrangement of heat pipes on the heat receiving block and causes an increase in airflow resistance. In this regard, according to the present aspect, since a spacing between two straight portions formed of the heat pipe is ensured, even if the number of heat pipes is increased, a passage of the wind is ensured and thus an airflow resistance can be suppressed.

Also, by using the U-shaped heat pipes, since a sufficient contact area can be ensured between the fins and the heat pipes, it is possible to increase fin efficiency, and at the same time, since there is an increased number of joining points between the fins and the heat pipes, vibration resistance also improves.

According to another aspect of the present invention, in the aforementioned aspect, the heat pipe group further includes an L-shaped heat pipe having a bottom portion having a bent part and a straight portion that is linear, the U-shaped heat pipes and the L-shaped heat pipes being provided to stand alternately on the heat receiving block with the U-shaped face of the U-shaped heat pipe and an L-shape face of the L-shaped heat pipe being perpendicular to a wind direction of an incoming wind, each of the straight portions of the U-shaped heat pipes and the L-shaped heat pipes being provided to incline upwardly in a case where the surface of the heat receiving block whereto the heat pipe group is attached is arranged perpendicular to the direction of gravity.

With the aspect described above, in addition to the aforementioned aspect, it is possible to control the wind path resistance by combining the L-shaped heat pipes based on the arrangement of the U-shaped heat pipe. Accordingly, the cooling efficiency can be further improved. Particularly, combining the L-shaped heat pipes at a downstream side where the cooling efficiency is relatively low due to a decrease in wind velocity may contribute to equalization of the cooling efficiency at the upstream and the downstream.

Another aspect of the present invention is characterized in that, in one of the aspects described above, a heat equalizing member that thermally connects a plurality of heat pipes is provided along the wind direction at a bottom portion of a plurality of the heat pipe groups that are provided to stand on the heat receiving block.

According to the aspects described above, heat can be further equalized in the wind direction by placing the heat equalizing member at the bottom portion of the heat pipe. Also, when the heat equalizing member is a heat equalizing heat pipe, an effect of heat equalization in the wind direction further increases.

### Effects of Invention

According to the aforementioned invention, it is possible to provide a cooling apparatus having an improved cooling capacity and vibration resistance, while reducing an airflow resistance and ensuring a sufficient contact area between the fins and the heat pipes.

### Brief Description of Drawings

[FIG. 1] Fig. 1 is a perspective view showing a cooling apparatus of a first embodiment of the present invention.
[FIG. 2] FIG. 2 is a front view showing the cooling apparatus of the first embodiment of the present invention.
[FIG. 3] FIG. 3 is a rear view showing the cooling apparatus of the first embodiment of the present invention.
[FIG. 4] FIG. 4 is a plan view showing the cooling apparatus of the first embodiment of the present invention.
[FIG. 5] FIG. 5 is a bottom plan view showing the cooling apparatus of the first embodiment of the present invention.
[FIG. 6] FIG. 6 is a right side view showing the cooling apparatus of the first embodiment of the present invention.
[FIG. 7] FIG. 7 is a left side view showing the cooling apparatus of the first embodiment of the present invention.
[FIG. 8] FIG. 8 is a schematic diagram showing an arrangement of heat pipes in the cooling apparatus of the first embodiment of the present invention.
[FIG. 9] FIG. 9A is a schematic diagram showing a cooling apparatus of a second embodiment of the present invention, and FIG. 9B is a left side view thereof.
[FIG. 10] FIG. 10A is a schematic diagram showing a cooling apparatus of a third embodiment of the present invention, and FIG. 10B is a left side view thereof.
[FIG. 11] FIG. 11A is a schematic diagram showing a cooling apparatus of a fourth embodiment of the present invention, and FIG. 11B is a left side view thereof.
[FIG. 12] FIG. 12A is a schematic diagram showing a conventional cooling apparatus, and FIG. 12B is a left side view thereof.
[FIG. 13] FIG. 13A is a schematic diagram showing a conventional cooling apparatus, and FIG. 13B is a left side view thereof.

### Description of the Preferred Embodiments

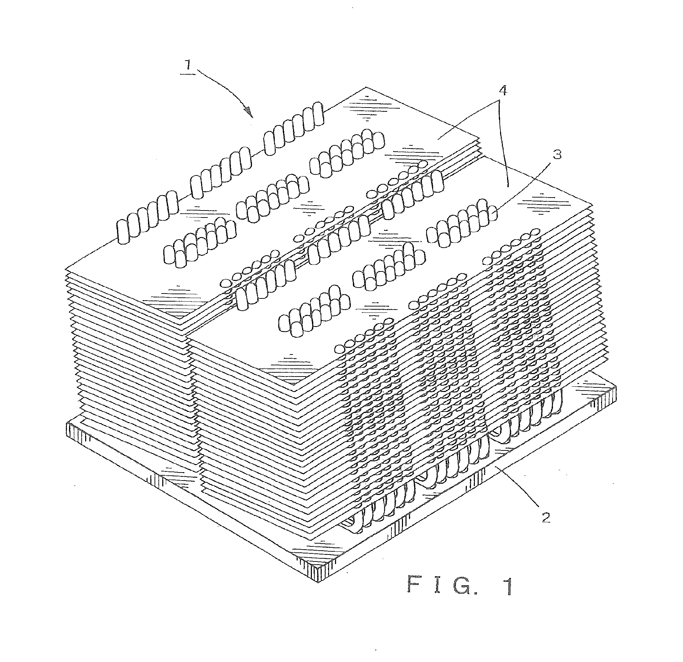

Hereinafter, embodiments for implementing the present invention (hereinafter, simply referred to as "embodiments") will be described with reference to FIGS. 1 to 10B.

### [1. First Embodiment]

As shown in FIG. 1, a cooling apparatus 1 of a first embodiment of the present invention includes a heat receiving block 2 that is thermally connected to an electronic component that constitutes a heating element, a heat pipe 3 that is provided to stand on a surface of the heat receiving block 2 and configured to receive heat from the heat receiving block 2 and to transport the heat, and a plurality of fins 4 attached to the heat pipe 3. A plurality of the heat pipes 3 are provided to stand on the heat receiving block 2 to form a heat pipe group.

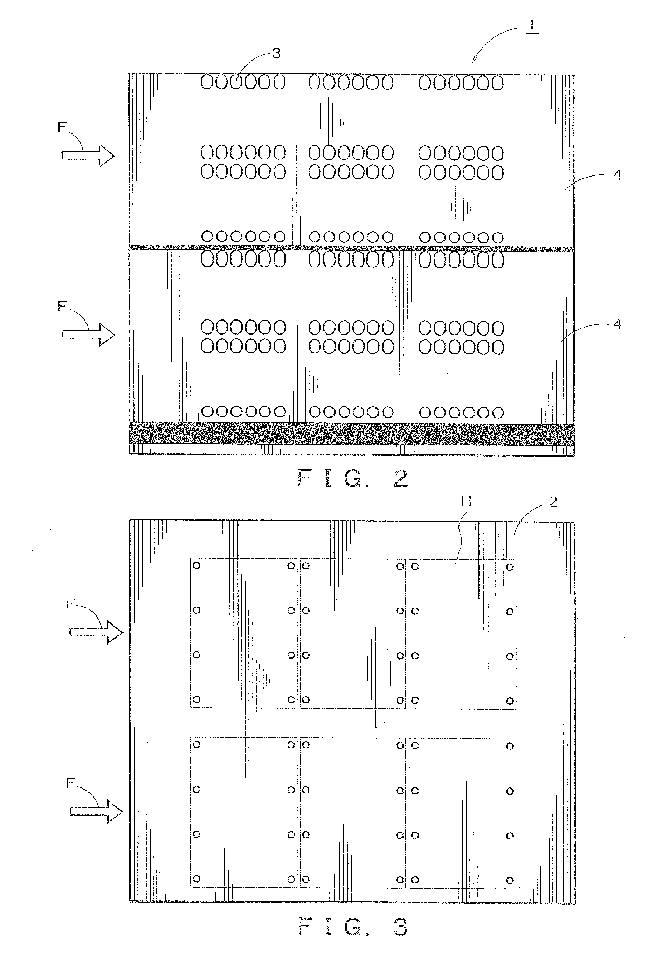

The heat receiving block 2 is formed of an aluminum block which is rectangular as shown in a rear view in FIG. 3, and which has attachment regions H on a reverse face as indicated by broken lines in FIG. 3, which attachment regions H being for attaching a plurality of (here, six) electronic components constituting a heating element. Note that eight circles indicated along a broken line frame represent holes for attaching an electronic component. As shown in a front view in FIG. 2 and a schematic diagram in FIG. 8, heat pipe groups are provided on a front face side of the heat receiving block 2 at positions corresponding to the arrangement of the electronic components described above. The heat pipes 3 are arranged in rows in a direction parallel to a wind direction F shown by arrows in FIGS. 2 and 8 to form a two-row heat pipe group. The fins 4 are attached to each of the heat pipe groups constituted by two rows. Note that, the wind direction F may be a wind direction opposite to the direction of arrows. The same applies to the following description.

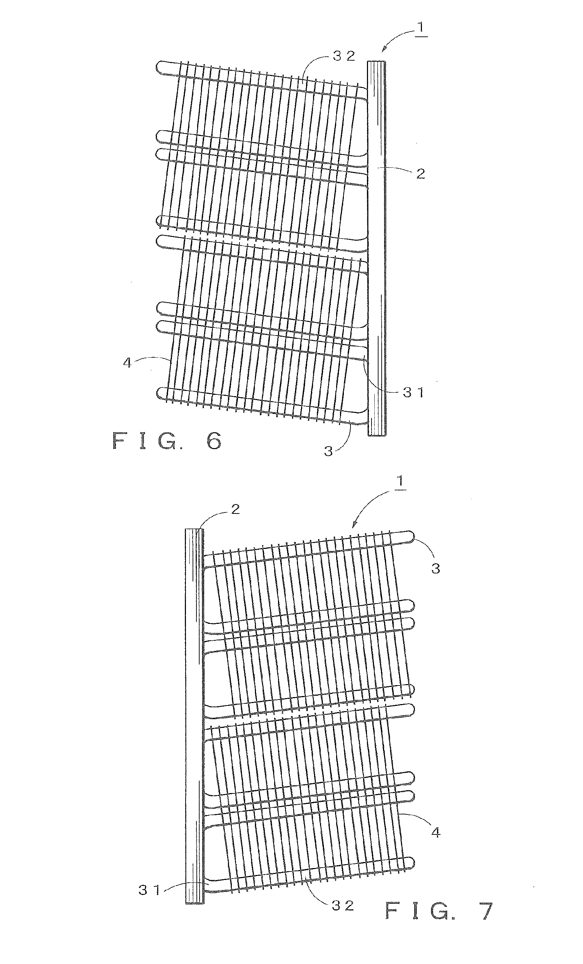

As shown in right and left side views in FIGS. 6 and 7, the heat pipe 3 has a U-shape including a bent bottom portion 31 and linear straight portions 32. As shown in FIG. 8, the heat pipe 3 is provided to stand on the heat receiving block 2 with a U-shaped face of the U-shape being arranged perpendicular to a wind direction F shown by arrows in the drawing. Further, the heat pipes 3 are arranged in such a manner that the heat pipes next to each other are disposed in an overlapped manner in the wind direction, and preferably, the straight portions 32 of the heat pipes 3 are disposed along a straight line in the wind direction F.

Further, as shown in FIGS. 6 and 7, as a state of use, in a case where the heat receiving block 2 serving as a attaching surface of the heat pipes 3 is arranged in a vertical direction, the U-shape of the heat pipe 3 is formed in such a manner that the straight portions 32 are both inclined upward.

Here, an angle of inclination is about 7 to 10 degrees upward with respect to a horizontal plane. This is an angle which is designed to be greater than a cant (angle of inclination) of rails for railway vehicles or the like whereto the cooling apparatus 1 of the present embodiment is installed. That is, in a case where the angle of inclination of the straight portion 32 of the heat pipe 3 is smaller than the cant angle, the heat pipe 3 is in a top heat state in which the heat receiving side of the heat pipe 3 is higher than the heat dissipation side. Accordingly, the angle is determined as described above to prevent this and maintain a bottom heat state.

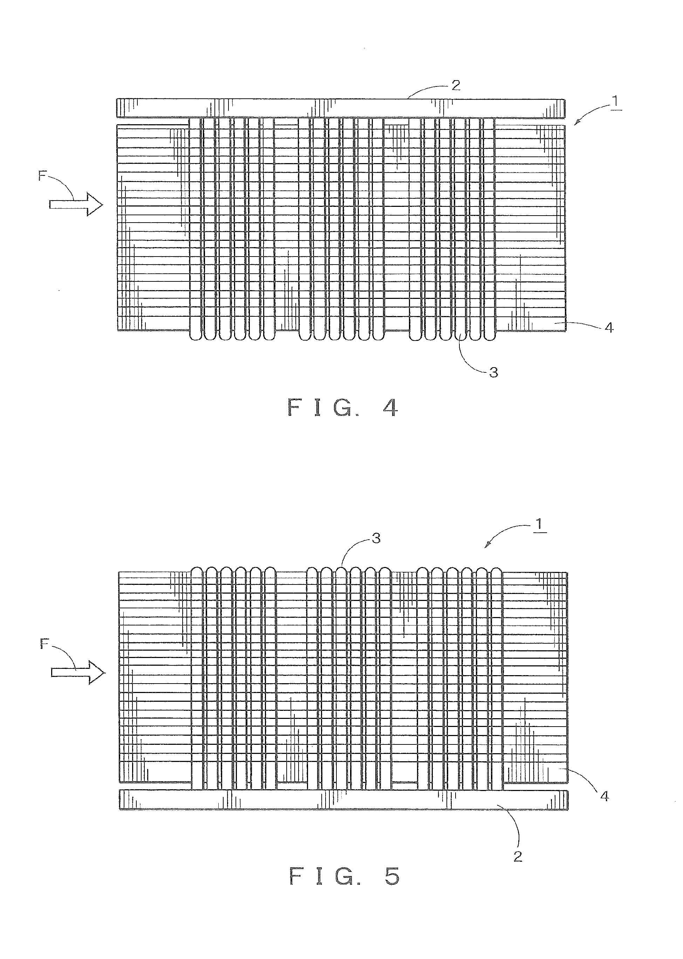

As shown in Fig. 1, the fins 4 are attached to each of the heat pipe groups constituted by two rows, and, as shown in FIGS. 4 and 5, at each row, disposed in a stacked manner at a predetermined pitch. Each of the fins 4 is provided with a plurality of burrings at positions corresponding to the heat pipes 3 for press-fitting the heat pipes 3. The fins 4 are pressure bonded to the heat pipes 3 by press-fitting the heat pipes 3 at the burrings.

Note that, as shown in the right and left side views of FIGS. 6 and 7, the fins 4 are attached to the two rows of heat pipes 3 by press-fitting in such a manner that the pitch and the number of fins are equivalent between the respective sets of fins 4. As described above, since the straight portions 32 of the heat pipe 3 are formed at a predetermined inclination with respect to the horizontal direction, three fins 4 on either sides are not aligned.

With the cooling apparatus 1 of the present embodiment described above, an airflow resistance can be suppressed, since the heat pipe 3 formed in a U-shape is disposed on the heat receiving block 2 with a U-shaped face thereof being arranged perpendicular to the wind direction F. As shown in FIG. 12, conventionally, since the U-shaped heat pipe is disposed with the U-shaped face thereof being arranged parallel to the wind direction F, an increase in the number of heat pipes will result in a dense arrangement of heat pipes on the heat receiving block and causes an increase in airflow resistance. In this regard, according to the present embodiment, since a spacing between two straight portions 32 of the heat pipe 3 is ensured, even if the number of heat pipes 3 is increased, a passage of the wind is ensured and thus an airflow resistance can be suppressed.

Also, by using the U-shaped heat pipes 3, since a sufficient contact area can be ensured between the fins 4 and the heat pipes 3, it is possible to increase fin efficiency, and at the same time, since there is an increased number of joining points between the fins 4 and the heat pipes 3, vibration resistance also improves.

Regarding a case in which the U-shaped heat pipe is disposed with the U-shaped face being arranged vertically, a working fluid may accumulate at a bent portion located at a lower part, and particularly, there is a concern of pipe bulging when frozen. This can be controlled by using a wick with a high capillary force in the heat pipe 3.

### [2. Second Embodiment]

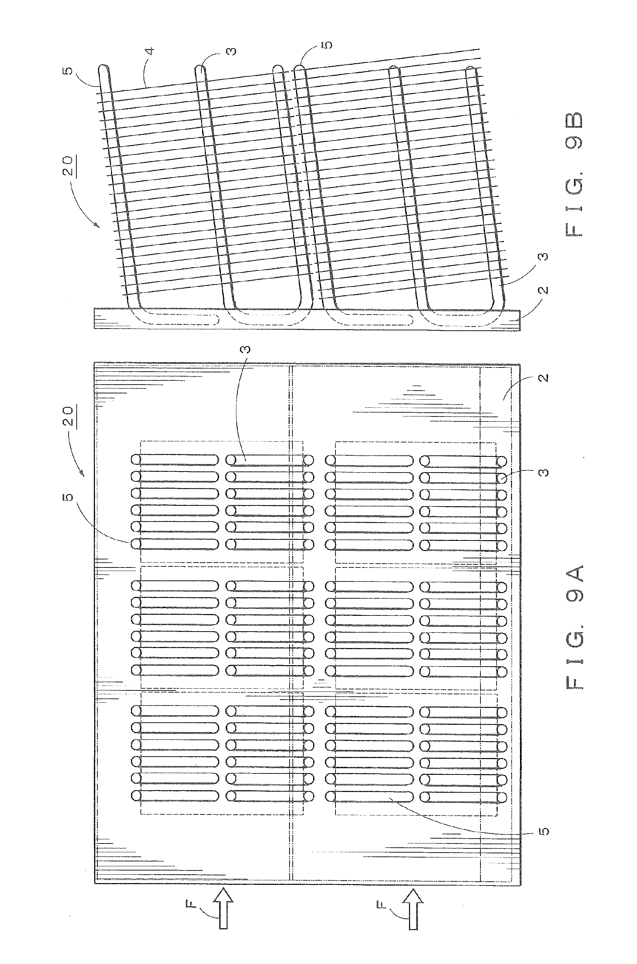

A cooling apparatus 20 of the second embodiment of the present invention will be described with reference to FIG. 9A and 9B. The cooling apparatus 20 of the present embodiment has a configuration in which L-shaped heat pipes 5 are used in place of some of the U-shaped heat pipes 3 in the heat pipe group provided in the cooling apparatus 10 of the first embodiment.

As shown in FIG. 9A, in the cooling apparatus 20, the heat pipes 3 and the heat pipes 5 constituting the heat pipe group have similar arrangements on a flat surface, and as shown in the drawing with arrows, provided to stand on the heat receiving block 2 with a U-shaped face or an L-shaped face of the heat pipe being arranged perpendicular to a wind direction F of an incoming wind. The heat pipes 3 and the heat pipes 5 next to each other are disposed in an overlapped manner in the wind direction and form a heat pipe group.

In the cooling apparatus 20, at an upper position in the drawing, the L-shaped heat pipes 5 are arranged in a row in the wind direction, and below this, the U-shaped heat pipes 3 are arranged in a row in the wind direction. A combination of the two-row heat pipes is provided further below in a repeated manner.

In the present embodiment, the heat pipe group may be constituted by any combination of the U-shaped heat pipes 3 and the L-shape heat pipes 5. For example, a combination of the U-shaped heat pipes 3 provided at an upstream side of the wind and the L-shape heat pipes 5 provided at a downstream side is also possible. In other words, as long as the U-shaped face or the L-shaped face are arranged perpendicular to the wind direction F of the incoming wind, and the heat pipes 3 and the heat pipes 5 next to each other are disposed in an overlapped manner in the wind direction F, it is possible to provide a configuration based on an arrangement of the U-shaped heat pipes 3 of the first embodiment and appropriately replacing the U-shaped heat pipes 3 in this arrangement with the L-shaped heat pipes 5.

With the cooling apparatus 20 of the present embodiment described above, in addition to an effect of the first embodiment, the wind path resistance can be adjusted by forming the heat pipe group based on the arrangement of the U-shaped heat pipes 3 and combining the L-shaped heat pipes 5. Accordingly, the cooling efficiency can be further improved. Particularly, the L-shaped heat pipes 5 may be combined at a downstream side where the cooling efficiency is relatively low due to a reduced wind velocity, so as to contribute to equalization of the cooling efficiency between an upstream side and a downstream side.

### [3. Third and Fourth Embodiments]

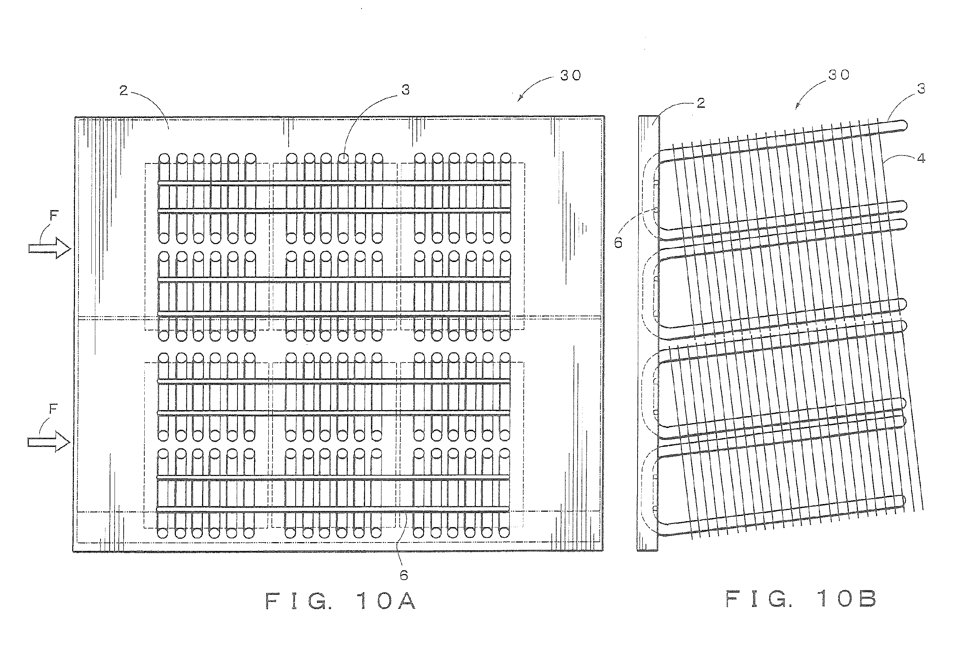

A cooling apparatus 30 of the third embodiment of the present invention will be described with reference to FIGS. 10A and 10B. The cooling apparatus 30 of the present embodiment is configured by adding a structure to the U-shaped heat pipes 3 of the cooling apparatus 10 shown in the first embodiment to seek for further improvement in the cooling efficiency.

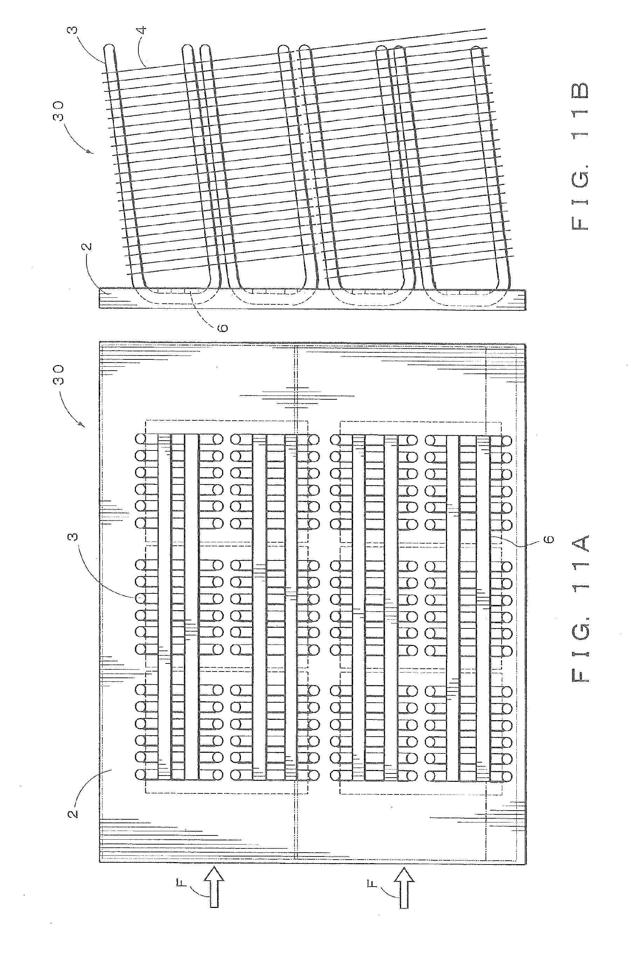

Specifically, as shown in FIGS. 10A and 10B, as a heat equalizing member 6 that thermally connects a plurality of heat pipes, a heat equalizing heat pipe is provided, along a wind direction F, at the bottom portions 31 which are portions where the heat pipes 3 are attached to the heat receiving block 2. The heat equalizing heat pipe may be a heat pipe that transports heat from an upstream side of the wind to a downstream side of the wind, a heat pipe that diffuses heat from the heat pipe 3 in a longitudinal direction of the heat equalizing heat pipe, and the like. In FIGS. 10A and 10B, a heat equalizing heat pipe is shown as the heat equalizing member 6. However, the heat equalizing member 6 is not limited to this example. For example, as shown in FIGS. 11A and 11B, the heat equalizing member 6 may be a rod-like member 6A, or a plate-like member, made of a material having a good thermal conductivity (e.g., copper). With the heat equalizing member 6 being provided as a rod-like member 6A, or a plate-like member, made of a material having a good thermal conductivity, heat from each of the heat pipes 3 can be diffused in a longitudinal direction of the heat equalizing member 6.

In the present embodiment, two heat equalizing members 6 are provided per each row of the heat pipes 3 forming the heat pipe group, at the bottom portions and over an entire range from the upstream to the downstream of the wind direction. The heat equalizing members 6 are secured to the heat pipes 3 by soldering or brazing.

In relation to a cooling efficiency, it is possible to appropriately change the range over which the heat equalizing member 6 is disposed in a upstream-downstream direction or the number of heat equalizing members 6 provided. Also, the heat equalizing member 6 may of course be employed in an embodiment, such as the cooling apparatus 20 of the second embodiment, in which a combination of the U-shaped and L-shaped heat pipes are used as the heat pipes.

According to the present embodiments described above, heat can be further equalized in the wind direction by disposing the heat equalizing member 6 on the bottom portion of the heat pipe 3. Note that, this effect becomes significant in a case where the heat equalizing member 6 is made of a material having a higher thermal conductivity than that of a material forming the heat receiving block 2. Further, in a case where the heat equalizing member 6 is a heat equalizing heat pipe, an effect of heat equalization in the wind direction further increases.

### List of Reference Signs

- 1, 20, 30: cooling apparatus
- 2: heat receiving block
- 21: elongated slot groove
- 3, 5: heat pipe
- 31: bottom portion
- 32: straight portion
- 4: fin
- 6: heat equalizing member
- H: electronic component

## Claims

1. A cooling apparatus comprising:
a heat receiving block that is thermally connected to a heating element;
a heat pipe group that is provided to stand on a surface of the heat receiving block, the heat pipe group being configured to receive heat from the heat receiving block and to transport the heat; and
a plurality of fins attached to the heat pipe group,
wherein a heat pipe constituting the heat pipe group is a U-shaped heat pipe having a bottom portion that is bent and a straight portion that is linear, the U-shaped heat pipe being provided to stand on the heat receiving block with a U-shaped face of the U-shaped heat pipe being perpendicular to a wind direction of an incoming wind, the heat pipes next to each other being disposed in an overlapped manner in the wind direction,
each of the straight portions being provided to incline upwardly in a case where a surface of the heat receiving block whereto the heat pipe group is attached is arranged perpendicular to a direction of gravity.

2. The cooling apparatus according to claim 1, wherein the heat pipe group further includes an L-shaped heat pipe having a bottom portion having a bent part and a straight portion that is linear,
the U-shaped heat pipes and the L-shaped heat pipes being provided to stand alternately on the heat receiving block with the U-shaped face of the U-shaped heat pipe and an L-shape face of the L-shaped heat pipe being perpendicular to a wind direction of an incoming wind,
each of the straight portions of the U-shaped heat pipes and the L-shaped heat pipes being provided to incline upwardly in a case where the surface of the heat receiving block whereto the heat pipe group is attached is arranged perpendicular to the direction of gravity.

3. The cooling apparatus according to claim 1 or 2, wherein a heat equalizing member that thermally connects a plurality of heat pipes is provided along the wind direction at a bottom portion of a plurality of the heat pipe groups that are provided to stand on the heat receiving block.

4. The cooling apparatus according to claim 3, wherein the heat equalizing member is a heat equalizing heat pipe.
